Europäisches Patentamt

European Patent Office

Office européen des brevets

(19)

(11) Numéro de publication: **0 176 154 B1**

# FASCICULE DE BREVET EUROPÉEN

(12)

(45) Date de publication du fascicule du brevet:
04.01.89

(51) Int. Cl.⁴: **G 02 B 6/42**

(21) Numéro de dépôt: 85201512.2

(22) Date de dépôt: 20.09.85

(54) **Procédé de fabrication d'un composant d'éxtrémite pour fibre optique, et composant ainsi obtenu.**

(30) Priorité: 28.09.84 FR 8414953

(43) Date de publication de la demande:
02.04.86 Bulletin 86/14

(45) Mention de la délivrance du brevet:
04.01.89 Bulletin 89/1

(84) Etats contractants désignés:
DE FR GB

(56) Documents cité:
EP-A-0 021 473
GB-A-2 016 163
GB-A-2 112 170
US-A-4 307 934

IEEE ELECTRO, vol. 7, mai 1982, pages 1-6, IEEE,
New York, US; D. STEVENSON: "An approach to
low cost fiber optics components"
IEEE Electro, vol. 17, 1982, page 27/2

(73) Titulaire: RTC- COMPELEC, 130, Avenue Ledru-
Rollin, F-75011 Paris (FR)
(84) Etats contractants désignés: FR

(73) Titulaire: N.V. Philips' Gloeilampenfabrieken,
Groenewoudseweg 1, NL- 5621 BA Eindhoven (NL)
(84) Etats contractants désignés: DE GB

(72) Inventeur: Thillays, Jacques, Societe Civile S.P.I.D
209 rue de l'Université, F-75007 Paris (FR)

(74) Mandataire: Jacquard, Philippe, SOCIETE CIVILE
S.P.I.D. 209, rue de l'Université, F-75007 Paris (FR)

## Description

La présente invention a trait à un procédé de fabrication d'un composant d'extrémité pour fibre optique, mettant en oeuvre des étapes de mise en place dans une embase d'un élément opto-électronique semi-conducteur sur lequel a été fixée une lentille sphérique de manière à constituer un système afocal et ainsi que de réalisation des connexions électriques.

Un tel procédé est connu de l'antériorité "IEEE Electro" vol. 7, mai 1983 page 6 (fig. 11). De par son principe, il ne permet pas de positionner l'ensemble élément opto-électronique - lentille sphérique avec une précision suffisante par rapport à un contour de référence éventuel de l'embase car le centrage d'une bille de petites dimensions par rapport à une embase est extrêmement délicat. Le capot de l'embase qui est monté sur le contour extérieur de l'embase présente une ouverture qui ne peut être centrée par rapport à la lentille sphérique.

Un procédé analogue est connu de l'art antérieur, par exemple de la demande de brevet européen publiée sous le n° 21 473. Il ne permet pas un positionnement précis de la lentille sphérique par rapport à une surface de référence de l'embase, et il en résulte que la mise en place ultérieure d'une fibre optique exige une recherche de positionnement suivant deux directions perpendiculaires de manière à faire coïncider avec précision son axe avec l'axe optique du système afocal, ceci constituant une opération longue et délicate. Cette recherche de positionnement est effectuée à l'aide d'un rayon lumineux émis par une diode laser constituant ledit élément opto-électronique.

Le procédé selon l'invention a pour objet de remédier à ces inconvénients.

Le procédé selon l'invention se caractérise par les étapes suivantes:

a) fixer en position l'ensemble lentille sphérique-élément opto-électronique au fond d'un boîtier de dimensions inférieures à celles de l'embase et présentant une partie latérale.

b) centrer par rapport à la lentille sphérique l'ouverture centrale d'un diaphragme supporté par une partie latérale du boîtier, ladite ouverture centrale ayant un diamètre sensiblement égal au diamètre extérieur d'une fibre optique et supérieur à celui de la lentille sphérique.

c) fixer en position ledit diaphragme ainsi centré, en constituant ainsi un composant intermédiaire.

d) disposer le composant dans ladite embase et le positionner par rapport à une surface de référence de celle-ci par introduction d'un ergot dans ladite ouverture centrale du diaphragme, ledit ergot étant lui-même positionné par rapport à un contour de référence coopérant avec la surface de référence.

e) fixer en position le composant intermédiaire ainsi centré.

Le fait que la lentille sphérique soit positionnée par rapport à une surface de référence de l'embase facilite le montage de la fibre car celle-ci peut être montée dans une férule de manière à être elle-même positionnée par rapport à un contour de référence de la férule coopérant lors de la présentation de la fibre avec la surface de référence de l'embase de telle sorte que la fibre se trouve pratiquement en face de l'ouverture centrale calibrée. Cette ouverture qui est positionnée avec une très grande précision par rapport à la lentille sphérique, positionne elle-même la fibre ce qui évite toute recherche de positionnement.

D'autre part, les étapes du procédé selon l'invention sont relativement simples à mettre en oeuvre, ce qui autorise une production en série à faible coût. En particulier, l'idée de base de ce procédé consiste à obtenir un positionnement de la lentille sphérique par deux étapes simples, la première entre la lentille sphérique et une ouverture centrale, et la seconde entre l'ouverture centrale et le contour de référence, alors qu'un tel positionnement serait difficile à réaliser en une seule étape du fait des ordres de grandeur relatifs des dimensions de la lentille sphérique et de la surface de référence.

L'ouverture centrale remplit donc une double fonction, d'une part permettre ledit positionnement en deux étapes, et d'autre part centrer la fibre optique.

Selon une variante, la fixation en position de composant intermédiaire est réalisée en raccordant électriquement celui-ci à des terminaisons de l'embase. Le fond du boîtier est alors conducteur et l'étape de fixation en position de l'élément opto-électronique est telle que celui-ci se trouve en contact électrique avec le fond conducteur et le diaphragme est également électriquement conducteur et relié électriquement à l'élément opto-électronique, le diaphragme ou une entretoise se prolongeant en direction du fond du boîtier par une patte conductrice, la fixation en position du composant intermédiaire étant alors réalisée par soudure du fond conducteur et de la patte conductrice sur une première et une seconde terminaison de l'embase.

Selon une variante préférée qui permet que le composant soit muni d'une butée pour la fibre optique, on interpose avantageusement entre le diaphragme et la partie latérale du boîtier une entretoise, transparente au moins dans sa partie centrale.

Selon une variante, le procédé comporte des étapes supplémentaires pour équiper le composant d'une fibre optique, à savoir une étape d'introduction de la fibre dans l'ouverture centrale jusqu'à sa venue en butée sur l'entretoise, étape réalisée à l'aide d'une pièce d'introduction pourvue d'un profil tronconique de guidage de la fibre, et disposée sensiblement coaxialement à l'ouverture centrale du diaphragme, et une étape de blocage de la fibre en butée.

Selon un premier mode de mise en oeuvre, la pièce d'introduction est une férule de centrage présentant à sa partie avant ledit profil tronconique, et lors d'une étape d'introduction de la férule de centrage, celle-ci est centrée par coopération entre la surface de référence de l'embase et un premier contour de centrage de la férule de centrage coaxial audit profil tronconique, de telle sorte que ce dernier soit amené sensiblement coaxial à l'ouverture centrale du diaphragme, le procédé présentant également une étape de blocage en position de la fibre dans la férule de centrage et une étape de blocage de la férule de centrage en butée sur l'embase, ceci constituant ladite étape de blocage de la fibre en butée.

Selon un second mode de mise en oeuvre, la pièce d'introduction est un centreur, et le procédé comporte une étape d'introduction d'une férule de maintien équipée d'une fibre optique bloquée en position sur celle-ci de manière à dépasser d'une longueur donnée de sa partie avant, la férule de maintien étant centrée par coopération entre un second contour de centrage de la férule de maintien, coaxial à ladite fibre optique qui l'équipe, et la surface de référence de l'embase, et il comporte également une étape de blocage de la férule de maintien en position sur une butée, constituant ladite étape de blocage de la fibre en butée.

L'invention concerne également un composant d'extrémité pour fibre optique, pouvant être obtenu par ce procédé, et comprenant un élément opto-électronique semi-conducteur sur lequel a été fixée une lentille sphérique de manière à constituer un système afocal, l'ensemble opto-électronique-lentille sphérique étant mis en place dans une embase.

Ainsi qu'il a été mentionné ci-dessus, un tel composant selon l'art antérieur, nécessite lors du montage d'une fibre une recherche de positionnement de celle-ci suivant deux directions perpendiculaires, ceci constituant une opération longue et délicate.

Cette difficulté est évitée grâce au composant d'extrémité selon l'invention, lequel se caractérise en ce qu'il comporte un composant intermédiaire comportant un boîtier au fond duquel est fixé l'ensemble opto-électronique-lentille sphérique et un diaphragme fixé en position sur une partie latérale du boîtier de telle manière qu'il présente une ouverture centrale coaxiale à la lentille sphérique et de diamètre supérieur à celle-ci, en ce que le composant est lui-même fixé dans ladite embase de telle manière que l'ouverture centrale du diaphragme soit positionnée par rapport à une surface de référence de l'embase, en ce que le fond du boîtier est en contact électrique avec l'élément opto-électronique, en ce que le diaphragme ou une entretoise est électriquement conducteur et est relié électriquement à l'élément opto-électronique, et en ce que le diaphragme ou l'entretoise se prolonge en direction du boîtier par une patte conductrice, le fond conducteur et la patte conductrice constituant les liaisons électriques du composant intermédiaire. Lesdites liaisons conductrices peuvent être alors reliées électriquement avec une première et une seconde terminaison conductrice de l'embase de manière à assurer également le maintien en position du boîtier sur l'embase.

Selon une variante préférée, la entretoise est transparente au moins dans sa partie centrale, et est disposée entre le diaphragme et la partie latérale du boîtier, de manière à servir de butée à une fibre optique introduite dans l'ouverture centrale du diaphragme lors de l'utilisation du composant d'extrémité. Le diaphragme peut porter ladite patte conductrice.

Selon un premier mode de réalisation de cette variante, une férule de centrage présente à sa partie avant un profil tronconique qui sert de pièce d'introduction de la fibre optique. La férule de centrage comporte dans ce but à sa partie centrale un contour de centrage coaxial au profil tronconique et coopérant avec la surface de référence de l'embase pour amener aux jeux près la partie tronconique de la férule de centrage coaxiale à l'ouverture centrale du diaphragme, ainsi qu'un moyen pour assurer le blocage de la fibre.

Selon un second mode de réalisation de cette variante, l'introduction de la fibre est facilitée par un centreur présentant un profil tronconique qui est sensiblement coaxial à l'ouverture centrale du diaphragme, la fibre optique étant bloquée en position sur une férule de maintien, de manière à dépasser d'une longueur donnée de sa partie avant. La férule de maintien porte un second contour de centrage centré par rapport à la fibre optique, assurant le centrage de la férule de maintien par rapport à la surface de référence de l'embase, et la férule de maintien est bloquée en position sur une butée de l'embase par un moyen approprié connu en soi.

L'invention sera mieux comprise à la lecture de la description qui va suivre, donnée à titre d'exemple non limitatif, en liaison avec les figures qui représentent:

- les figures 1a et 1b, respectivement en coupe verticale et en vue de dessus un composant d'extrémité selon un mode de réalisation de l'invention,
- les figures 2a et 2b respectivement les pièces constitutives du composant intermédiaire, et celui-ci assemblé,
- les figures 3a à 3d, les étapes de fabrication du composant des figures 1a et 1b,
- la figure 4a une variante d'un micro-composant selon l'invention sans entretoise transparente formant butée pour la fibre et la figure 4b, le montage d'une fibre à l'aide d'un centreur,
- les figures 5a, 6 et 5b respectivement une coupe verticale d'un férule de centrage selon l'invention, un composant équipé d'une fibre montée dans une telle férule, et un calibre de montage du composant intermédiaire dans l'embase,

- les figures 7a et 7b respectivement en vue latérale un demi élément de férule de maintien et en coupe verticale une férule de maintien équipée d'une fibre,
- les figures 8a et 8b respectivement en coupe horizontale et verticale, un composant équipé d'une telle férule, et mettant en oeuvre un centreur,

et les figures 9a et 9b une autre variante selon l'invention.

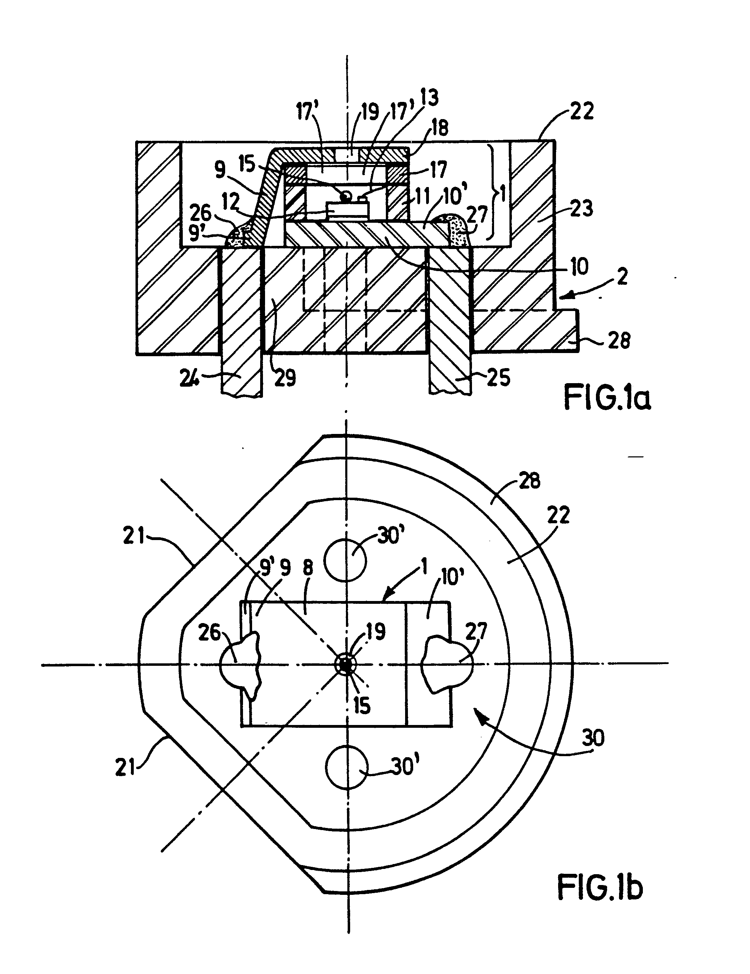

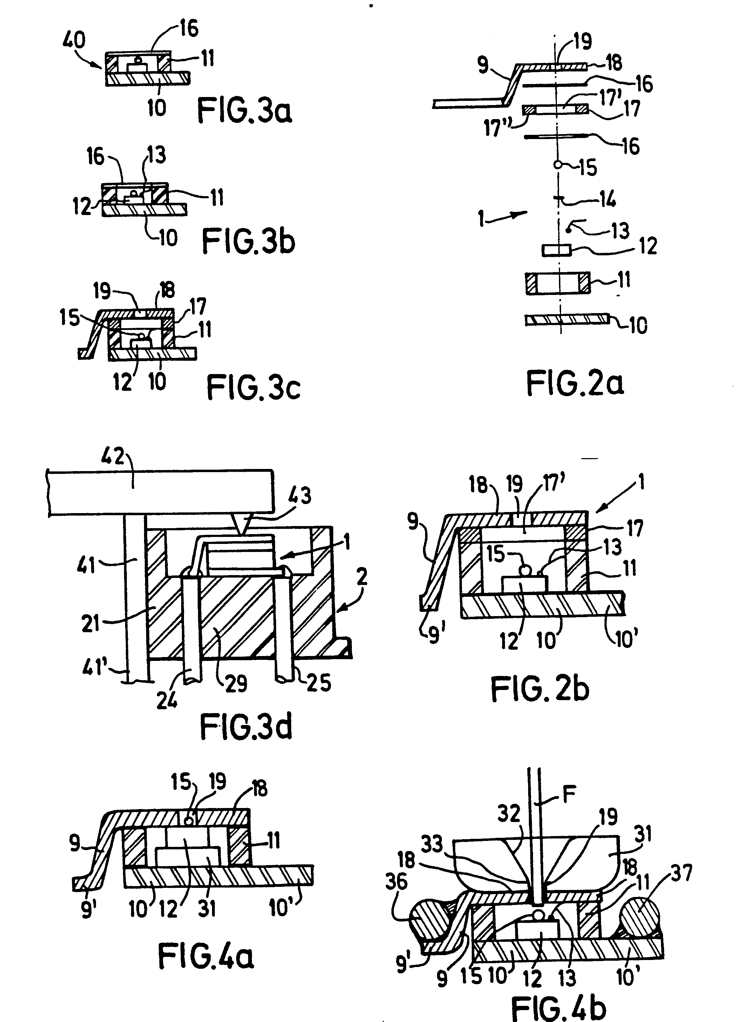

Selon les figures 1a et 1b, un composant intermédiaire 1 est monté dans une embase 2. Le composant intermédiaire 1, représenté séparément à le figure 2b est assemblé suivant les étapes des figures 3a à 3d, à partir des éléments représentés figure 2a.

A la figure 2a, le composant intermédiaire comporte un fond 10, une pièce annulaire 11 formant la partie latérale du boîtier, un cristal semi-conducteur 12 photo-émetteur ou photorécepteur selon le type de composant envisagé, une lentille sphérique constituée par une micro-bille de verre 15 et un diaphragme 18 pourvu d'une ouverture centrale 19 coaxiale à la micro-bille 15 et dont le diamètre sensiblement égal au diamètre extérieur d'une fibre nue est supérieur à celui de la micro-bille de verre 15, et le cas échéant une entretoise 17 dont au moins la partie centrale 17' est transparente et qui peut servir de butée à la fibre lors de son montage.

La présence de cette entretoise 17 n'est qu'optionnelle. Etant donné que le système est afocal, il existe une latitude importante pour disposer la fibre axialement, la distance de celle-ci à la micro-bille 15 ayant peu d'importance. Par contre, il convient de remarquer que l'entretoise 17, qu'on s'en serve ou non comme butée, présente l'avantage de rendre le composant intermédiaire étanche.

Les figures 3a à 3d, envisagent le cas non limitatif où le diaphragme 18 et le fond 10 servent également de connexion électrique pour le composant 12. Dans ce but, la périphérie ce l'entretoise 17 est conductrice de même que le fond 10, la pièce annulaire 11 étant bien entendu isolante.

A la figure 3a, la pièce annulaire 11 est collée sur le fond 10, et le cristal 12 soudé ou brasé au centre du fond 10 après collage de la micro-sphère 15, à l'aide de colle polyimide 14 (figure 2a). On notera que le centrage relatif du cristal 12 et de la pièce annulaire 11 ne requiert pas de précision particulière.

A la figure 3b, la pièce annulaire 11 est revêtue d'une préforme annulaire 16, et un fil de connexion électrique est soudé ou brasé à une extrémité sur le cristal 12, son autre extrémité étant amenée sur la préforme 16, sur laquelle est ultérieurement soudée ou brasée la périphérie de l'entretoise 17 (fig. 3c), puis le diaphragme 18 après que son ouverture 19 ait été amenée concentrique à la micro-sphère 15, de manière à obtenir le composant intermédiaire. Cette opération de centrage se fait facilement avec une précision meilleure que 10 microns sous microscope ou binoculaire du fait que la micro-sphère 15 et l'ouverture 19 ont des diamètres du même ordre de grandeur: 80 à 100 microns pour la micro-bille c'est-à-dire un diamètre sensiblement supérieur à celui du coeur d'une fibre et 200 microns pour l'ouverture 19 par exemple c'est-à-dire un diamètre de l'ordre du diamètre nominal externe (185 microns) d'une fibre nue, la micro-bille 15 ayant un diamètre en tous cas inférieur à celui de l'ouverture 19.

La dernière opération (figure 3d) consiste à disposer le composant intermédiaire dans l'embase, et à le fixer en position dans celle-ci de telle manière qu'il soit positionné par rapport à une surface de référence de celle-ci, par exemple avec une précision de l'ordre de 10 à 20 microns. Dans le cas de figures 1a et 1b, cette surface de référence est constituée de manière bien connue par deux profils saillants 21 définissant un V. Le positionnement du composant intermédiaire s'effectue dans un calibre présentant un bras 42 portant un ergot de centrage avantageusement tronconique 43 dont la position est déterminée par rapport à une surface de calibrage 41' ménagée dans une portion verticale 41 du calibre et correspondant à la surface de référence du composant intermédiaire. Le positionnement du micro-composant s'effectue alors de la manière suivante. La surface de référence, ici deux profils saillants 21 en forme de V est mise en contact avec la surface de calibrage 41', dans ce cas deux rainures en forme de V, et on fait coulisser l'embase 2 le long de la surface de calibrage 21' en direction du bras 42. Le composant intermédiaire 1 ayant été approximativement pré-centré, ce qui est simple étant donné que l'ouverture 19 a un diamètre d'environ 0,2 mm, l'ergot de centrage tronconique 43 vient s'introduire dans l'ouverture centrale 19 et le mouvement de coulissement de l'embase 2 se poursuit jusqu'à ce que l'ergot 43 produise, du fait de son évasement, un effet de butée. On peut ainsi obtenir un positionnement de bonne précision (d'une précision de l'ordre de 10 microns). Il suffit ensuite de fixer la position du composant intermédiaire 1 dans l'embase 2, par collage ou tout autre moyen. Dans le cas d'espèce, la fabrication est simplifiée du fait que c'est la soudure des connexions électriques qui assure en même temps cette fonction.

Selon les figures 1a et 1b, l'embase 2 comporte une base 29 pourvu d'un décrochement 28 formant butée, une paroi latérale 23, une surface supérieure 22, une cavité 30 et les deux profils 21 en forme de V. Le composant intermédiaire 1 est disposé dans la cavité 30. Deux terminaisons conductrices 24 et 25 traversent la base 29 et affleurent au fond de la cavité 30. Le brasage des liaisons conductrices du composant intermédiaire est effectué grâce à une patte conductrice 9 prolongeant le diaphragme 18 en direction du fond 10 et pourvu d'une extrémité repliée 9' au niveau de laquelle la patte 9 est brasée en 26 à la terminaison 24. Le fond 10 est pourvu d'un prolongement 10' permettant son brasage en 27 sur la terminaison 25.

Selon la figure 4a, le composant intermédiaire ne comporte pas d'entretoise 17. L'élément opto-électronique 12 est surélevé par un support conducteur 31 de telle sorte que sa surface affleure le plan de la partie supérieure de la pièce annulaire 11. Le diaphragme 18 vient alors former contact électrique directement sur la surface de l'élément 12, une pâte conductrice étant utilisée pour assurer un bon contact.

La figure 4b illustre la mise en place d'une fibre F à l'aide d'un centreur 31 pourvu d'un profil tronconique, avantageusement prolongé par une extrémité cylindrique 33 de même diamètre nominal que l'ouverture 19. On remarquera que le composant intermédiaire est analogue à celui de la figure 2b à l'exception de l'entretoise 17, et que sa fixation en position n'est pas réalisée par l'intermédiaire de ses liaisons électriques mais par collage du fond 10 par exemple, ou bien par serrage mécanique. Ces liaisons comportent en effet un fil 37 brasé sur le prolongement 10' de fond 10 et un fil 36 brasé sur la partie concave de la patte 9.

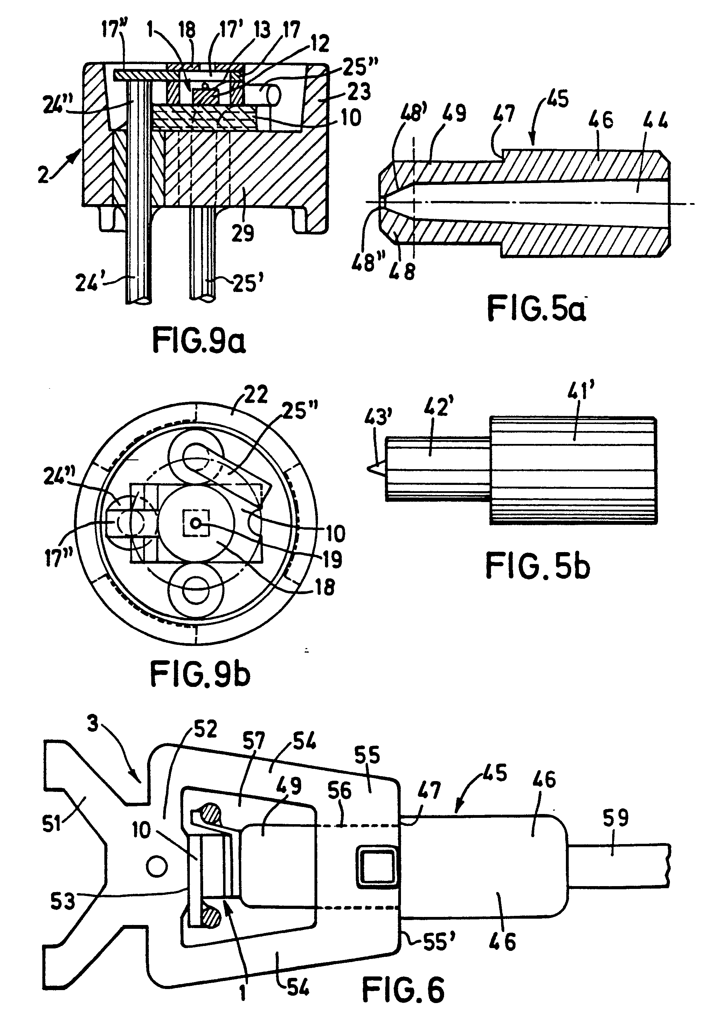

Selon les figures 5a et 6, le centrage de la fibre est réalisé par une férule de centrage 45 pourvue à sa partie avant 48 d'un profil tronconique 48', avantageusement prolongé par une extrémité cylindrique 48'' de même diamètre nominal que l'ouverture 19 le profil tronconique 48' et l'extrémité 48'' étant coaxiaux à une partie centrale cylindrique 49. La férule de centrage 45 présente depuis sa partie arrière jusqu'au profil 48' un profil tronconique 44 de faible angle d'ouverture permettant de faciliter le guidage de l'extrémité de la fibre nue F c'est-à-dire pourvue de sa seule gaine optique qui dépasse de sa gaine de protection mécanique 59, ainsi que le guidage de cette dernière.

L'embase 3 comporte un socle 52 auquel sont avantageusement attachées des ailettes de refroidissement 51, et un rebord plan 53 pour recevoir le fond 10 du composant intermédiaire 1. Le socle 52 se prolonge de chaque côté et en direction opposée à celle des ailettes par deux parois latérales 54 qui se rejoignent à une partie arrière 55. La surface de référence de l'embase 3 est constituée par un alésage 56, celui-ci coopérant avec la partie centrale cylindrique 49 de la férule, de manière que l'axe du profil tronconique 48' et le cas échéant de l'extrémité cylindrique 48'' passe par le centre de la micro-sphère 15. La partie arrière 46 de la férule 45 présente un diamètre supérieur à celui de sa partie centrale 49 de sorte qu'elle vient en butée sur la surface 55' de l'embase grâce au décrochement 47. La longueur de la partie centrale 49, de la partie avant 48 et l'épaisseur du composant intermédiaire 1 sont calculées de manière à former un empilement depuis le décrochement 47 en butée sur la surface 55' jusqu'au rebord 53. La férule 45 est fixée à sa position de butée par des moyens non représentés (collage, bague etc...), après quoi la fibre F est introduite dans la férule 45. En cas de besoin la fibre F peut être fixée dans la férule 45 par un moyen approprié, celui-ci consistant par exemple en de la colle introduite dans le profil tronconique 44.

La figure 5b montre un calibre permettant de positionner le composant intermédiaire 1, sur le rebord 53. Il comporte une section cylindrique arrière 41' de diamètre nominal égal à celui de l'alésage 56 avec des tolérances permettant un coulissement à très faible jeu, une section cylindrique avant 42' de plus faible diamètre portant un ergot de centrage tronconique 43' coaxial avec une grande précision à la section cylindrique 41'.

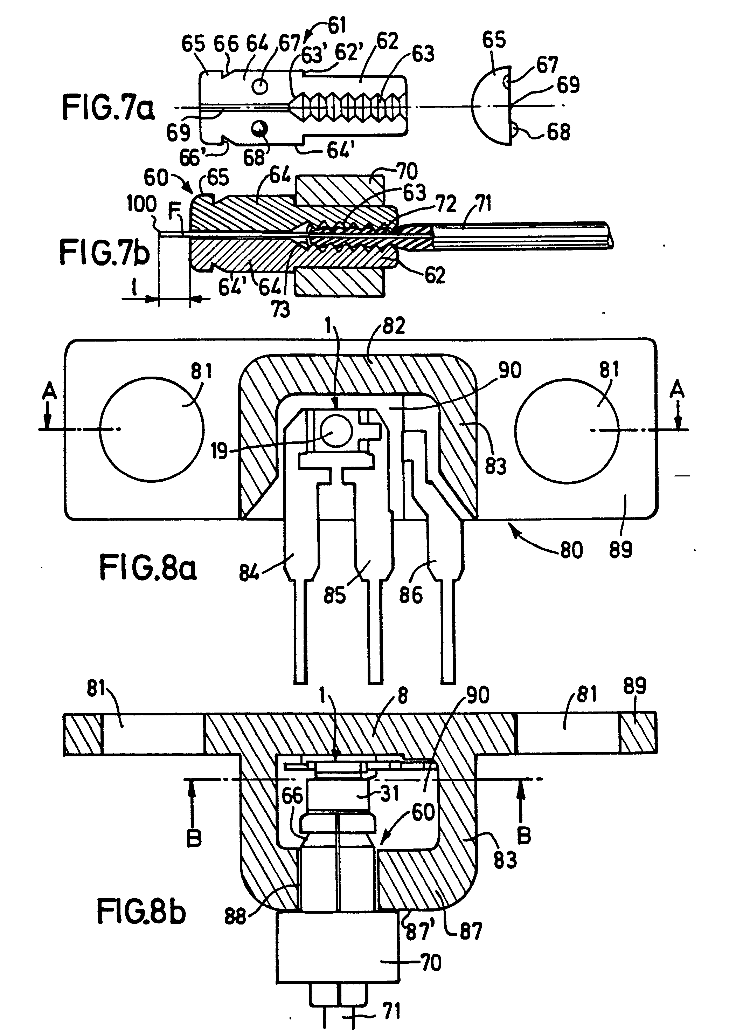

Selon les figures 7a et 7b et 8a et 8b, une férule de maintien 60 est conçue de telle manière que la fibre nue F est bloquée en position et dépasse de sa partie avant 65 d'une longueur l bien déterminée. Ce mode de réalisation convient plus particulièrement quoique non exclusivement au cas où on ne met pas en oeuvre une entretoise transparente 17.

Selon la figure 7a, la férule de maintien 60 est en deux demi-cylindres identiques 61 fabriqués de préférence par moulage et comportant chacune une rainure 69, par exemple en forme de V, destinée à maintenir axialement la fibre nue F sans la comprimer, cette rainure s'étendant depuis une partie avant 65 jusqu'à déboucher · dans un demi-taraudage 63 par l'intermédiaire d'une section tronconique 63' permettant de guider la fibre F lors de son introduction. La partie centrale 64 est raccordée à la partie avant 65 par une rainure 66 présentant un décrochement 66' et à la partie arrière 62 par un décrochement 62' servant de butée à un bouchon 70. La partie centrale 64 comporte également des repères, à savoir un trou borgne semi-cylindrique 67 et une partie en relief 68, disposés de part et d'autre de l'axe de la rainure 69 et assurant également une fonction de détrompage.

Selon la figure 7b, la férule de maintien 60 assemblée est maintenue par le bouchon 70 venant en butée sur le décrochement 62'. Le bouchon 70 est introduit à force sur l'extérieur de la partie arrière cylindrique 62 ou bien vissé sur celle-ci. La partie avant 72 de la gaine 71 du câble de la fibre optique est bloqué dans les demi-taraudages 63 et la fibre optique nue F est guidée par les rainures 69 et dépasse de la partie avant 65 d'une longueur l donnée.

Aux figures 8a et 8b, l'embase correspondante 80 est équipée d'un composant intermédiaire 1 monté sur un socle 89, lequel présente deux alésages 81 permettant la fixation de l'embase sur un support. Une paroi verticale 82 bordée de deux ailes verticales 83 qui lui sont perpendiculaires entoure le composant intermédiaire sur trois côtés. Le quatrième côté est laissé libre pour laisser passage à des connexions électriques 84, 85 et 86, et également pour permettre un éventuel remplissage par de la résine.

Les deux ailes 83 et la paroi 82 sont coiffées par un bord supérieur 87 parallèle au socle 89 et présentant un alésage 88 de diamètre nominal égal à celui des parties centrales 64 de manière à permettre un coulissement à faible jeu. Un centreur 31 (cf. figure 4b) facilite l'entrée de la fibre nue F dans l'ouverture 19 du composant intermédiaire 1. La longueur l est choisie de telle manière que, lorsque le bouchon 70, lui-même en butée contre le décrochement 62, vient en butée sur la surface supérieure 87' du bord supérieur 87, l'extrémité avant 100 de la fibre nue F soit située proche de la micro-sphère 15 ou de l'entretoise transparente 17. Des divers exemples décrits ci-dessus, il ressort que le centrage de l'ouverture centrale 19 par rapport à la micro sphère 15 se doit d'être d'une précision aussi élevée que possible car elle conditionne la coaxialité de la fibre F et de l'axe optique de l'ensémble micro-sphère 15 - élément opto électronique 12, alors que le positionnement de l'ouverture centrale 19 par rapport à la surface de référence de l'embase peut se satisfaire d'une précision moindre, mais suffisante pour permettre la présentation de la fibre à l'aide d'un contour tronconique.

Selon les figures 9a et 9b, l'entretoise 17 est, à l'exception de sa partie centrale transparente 17', réalisée en matériau conducteur et se prolonge par une patte 17'' formant contact électrique avec un prolongement 24'' d'une terminaison conductrice 24' de l'embase 2. L'entretoise 17 est connectée électriquement à une électrode de l'élément 12 par le fil 13. D'autre part, la base 10 du composant intermédiaire 1 est en contact électrique avec un prolongement recourbé 25'' d'une terminaison 25' de l'embase 2.

**Revendications**

1. Procédé de fabrication d'un composant d'extrémité pour fibre optique, mettant en oeuvre des étapes de mise en place dans une embase d'un élément opto-électronique semi-conducteur sur lequel a été fixée une lentille sphérique de manière à constituer un système afocal et de réalisation des connexions électriques caractérisé en ce qu'il comporte les étapes suivantes:

   a) fixer en position l'ensemble lentille sphérique (15) élément opto-électronique (12) au fond (10) d'un boîtier (40) de dimensions inférieures à celles de l'embase et présentant une partie latérale (11).

   b) centrer par rapport à la lentille sphérique (15) l'ouverture centrale (19) d'un diaphragme (18) supporté par la partie latérale (11) du boîtier (40), ladite ouverture centrale ayant un diamètre sensiblement égal au diamètre extérieur d'une fibre optique (F) et supérieur à celui de la lentille sphérique (15).

   c) fixer en position ledit diaphragme (18) ainsi centré, en constituant ainsi un composant intermédiaire (1).

   d) disposer le composant intermédiaire dans ladite embase (2, 3, 80) et le positionner par rapport à une surface de référence (21, 56, 88) de celle-ci par introduction d'un ergot (43) dans ladite ouverture centrale (19) du diaphragme (18), ledit ergot (43) étant lui-même positionné par rapport à un contour de référence (41) coopérant avec la surface de référence (21, 56, 88).

   e) fixer en position dans l'embase (2) le composant intermédiaire (1) ainsi centré.

2. Procédé selon la revendication 1, caractérisé en ce qu'il comporte une étape où on interpose entre le diaphragme et la partie latérale (11) du boîtier (40) une entretoise (17) transparente au moins dans sa partie centrale (17'), celle-ci servant de butée à une fibre optique (F) introduite dans l'ouverture centrale (19) du diaphragme (18) lors de l'utilisation du composant d'extrémité.

3. Procédé selon une des revendications 1 ou 2, caractérisé en ce que le fond (10) du boîtier (40) est électriquement conducteur, et en ce que l'étape de fixation en position de l'élément opto-électronique (12) est telle que celui-ci se trouve en contact électrique avec ledit fond conducteur (10) et en ce que le diaphragme (11) ou une entretoise (17) est également électriquement conducteur de manière à être relié électriquement à l'élément opto-électronique (12), et se prolonge par une patte conductrice (9, 9'), la fixation en position du composant intermédiaire (12) étant alors réalisée par soudure du fond conducteur (10) et de la patte conductrice (9, 9') sur une première (24) et une seconde (25) terminaison conductrice de l'embase (2).

4. Procédé selon la revendication 3, en vue de fournir un composant d'extrémité équipé d'une fibre optique (F) caractérisé en ce qu'il comporte une étape d'introduction de la fibre (F) dans l'ouverture centrale (19) jusqu'à sa venue en butée sur l'entretoise (17) réalisée à l'aide d'une pièce d'introduction (32, 45) pourvue d'un profil tronconique (37, 48) de guidage de la fibre (F), et disposée sensiblement coaxialement à l'ouverture centrale (19) du diaphragme (18) et une étape de blocage de la fibre (F) en butée.

5. Procédé selon la revendication 4 caractérisé en ce que ladite pièce d'introduction est une férule de centrage (45) présentant à sa partie avant ledit profil tronconique (48), en ce que, lors d'une étape d'introduction de la férule de centrage (45), celle-ci est centrée par coopération entre la surface de référence (56) de l'embase et un premier contour de centrage (49) de la férule de centrage (45) coaxial audit profil tronconique (48) de telle sorte que ce dernier soit amené sensiblement coaxial à l'ouverture centrale (19) du diaphragme (18), et en ce qu'il comporte une étape de blocage en position de la fibre (F) dans la férule de centrage (45) et une étape de blocage de la férule de centrage (45) sur l'embase (3) ceci constituant ladite étape de blocage de la fibre en butée.

6. Procédé selon la revendication 4, caractérisé en ce que ladite pièce d'introduction est un centreur (31), en ce qu'il comporte une étape d'introduction d'une férule de maintien (60) équipée d'une fibre optique (F) bloquée en position (63, 72) sur celle-ci de manière à dépasser d'une longueur donnée (1) de sa partie avant (65), la férule de maintien étant centrée par coopération entre un second contour de centrage (64') de la férule de maintien (60) coaxial à ladite fibre optique (F) qui l'équipe, et la surface de référence (88) de l'embase (3) et en ce qu'il comporte une étape de blocage de la férule de maintien (60) en position sur une butée (87') constituant ladite étape de maintien de la fibre en butée.

7. Composant d'extrémité pour fibre optique comprenant un élément opto-électronique semi-conducteur sur lequel a été fixée une lentille sphérique de manière à constituer un système afocal, l'ensemble élément opto-électronique-lentille sphérique étant mis en place dans une embase caractérisé en ce qu'il comporte un composant intermédiaire (1) comportant un boîtier (40) au fond (10) duquel est fixé l'ensemble élément opto-électronique (12) -lentille sphérique (15) et un diaphragme (18) fixé en position sur une partie latérale (11) du micro-boîtier (40) de telle manière qu'il présente une ouverture centrale (19) coaxiale à la lentille sphérique (15) et de diamètre supérieur à celle-ci et en ce que le composant intermédiaire (1) est lui-même fixé dans ladite embase (2, 3, 80) de telle manière que l'ouverture centrale (19) du diaphragme (18) soit positionnée par rapport à une surface de référence de l'embase (2, 3, 80), en ce que le fond (10) du boîtier (40) est en contact électrique avec l'élément opto-électronique (12), en ce que le diaphragme (18) ou une entretoise (17) est électriquement conducteur de manière à être relié électriquement à l'élément opto-électronique (12) et en ce que le diaphragme ou l'entretoise (17, 18) se prolonge par une patte conductrice (9, 9'), le fond conducteur (10) et la patte conductrice (9, 9') constituant les liaisons conductrices du composant intermédiaire (1).

8. Composant d'extrémité selon la revendication 7, caractérisé en ce que l'entretoise (17) est transparente au moins dans sa partie centrale, et est disposée entre le diaphragme (18) et la partie latérale (11) du micro-boîtier (40), de manière à servir de butée à une fibre optique (F) introduite dans l'ouverture centrale (19) du diaphragme (18) lors de l'utilisation du composant d'extrémité.

9. Composant d'extrémité selon la revendication 8, caractérisé en ce que lesdites liaisons conductrices sont reliées électriquement avec une première (24) et une seconde (25) terminaison conductrice de l'embase (2) de manière à assurer également le maintien en position du boîtier (40) sur l'embase (2).

10. Composant d'extrémité selon une des revendications 8 ou 9, et équipé d'une fibre optique caractérisé en ce qu'il comporte une pièce d'introduction de la fibre optique constituée par une férule de centrage (45) présentant à sa partie avant (48') un profil tronconique (48), à sa partie centrale (49) un contour de centrage (49') coaxial au profil tronconique (48) et coopérant avec la surface de référence (56) de l'embase pour amener, aux jeux près, la partie tronconique (48) de la férule de centrage (45) coaxiale à l'ouverture centrale (19) du diaphragme (18), et un moyen (57) pour assurer le blocage de la fibre.

11. Composant d'extrémité selon une des revendications 8 ou 9, et équipé d'une fibre optique, caractérisé en ce qu'il comporte un centreur (31) présentant un profil tronconique (32) sensiblement coaxial à l'ouverture du diaphragme (18), une férule de maintien (60) équipée d'une fibre optique (F) bloquée en position (63, 72) sur celle-ci de manière à dépasser d'une longueur donnée (1) de sa partie avant (65), la férule de maintien (61) étant centrée par coopération entre un second contour de centrage (64') de la férule de maintien, (60) centré par rapport à ladite fibre optique (F) qui l'équipe, et la surface de référence (88) de l'embase et en ce qu'il comporte un moyen (90) pour bloquer la férule de maintien (60) sur une butée (87') de l'embase (80).

**Patentansprüche**

1. Verfahren zum Herstellen einer Abschlußeinrichtung für eine optische Faser, einschließlich der Anordnung eines optoelektronischen Halbleiterelementes in einer Basis, wobei auf diesem Element eine sphärische Linse derart angeordnet ist, daß ein afokales System gebildet wird, sowie einschließlich der Herstellung elektrischer Verbindungen, dadurch gekennzeichnet, daß das Verfahren die folgenden Verfahrensschritte aufweist:

a) das Befestigen des aus der sphärischen Linse (15) und dem optoelektronischen Element (12) bestehenden Gebildes auf dem Boden (10) eines Gehäuses (40) mit Innenabmessungen, die kleiner sind als die der Basis, wobei dieses Gehäuse einen lateralen Teil (11) aufweist;

b) das Zentrieren der zentralen Öffnung (19) einer Blende (18) gegenüber der sphärischen Linse (15), wobei diese Blende an dem lateralen Teil (11) des Gehäuses (40) angeordnet ist, wobei diese zentrale Öffnung einen Durchmesser aufweist, der im wesentlichen dem Außendurchmesser einer optischen Faser (F) entspricht und größer ist als der der sphärischen Linse (15);

c) das Befestigen der Blende (18), und zwar derart zentriert, daß auf diese Weise eine Zwischeneinrichtung (1) gebildet wird;

d) das Anordnen der Zwischeneinrichtung in der Basis (2, 3, 80) und das Ausrichten der Einrichtung gegenüber einer Bezugsfläche (21, 56, 88) derselben, und zwar dadurch, daß in die zentrale Öffnung (19) der Blende (18) ein Stift (43) eingeführt wird, wobei dieser Stift (43) an sich gegenüber einem mit der Bezugsfläche (21, 56, 88) zusammenarbeitenden Bezugsrand (41) ausgerichtet ist;

e) das in der Basis (2) an ihrem Platz befestigen der auf diese Weise zentrierten Zwischeneinrichtung (1).

2. Verfahren nach Anspruch 1, dadurch gekennzeichnet, daß es einen Verfahrensschritt aufweist, bei dem zwischen der Blende und dem lateralen Teil (11) des Gehäuses (40) ein wenigstens im zentralen Teil (17') transparenter Steg (17) angeordnet wird, der, im Betrieb der Abschlußeinrichtung, an sich als Anschlag für eine in die zentrale Öffnung (19) der Blende (18) eingeführte optische Faser (F) wirksam ist.

3. Verfahren nach einem der Ansprüche 1 oder 2, dadurch gekennzeichnet, daß der Boden (10) des Gehäuses (40) elektrisch leitend ist und daß der Verfahrensschritt zum an seinem Platz Befestigen des optoelektronischen Elementes (12) derart durchgeführt wird, daß dieses Element mit dem leitenden Boden (10) elektrischen Kontakt macht und daß die Blende (11) oder ein Steg (17) ebenfalls elektrisch leitend sind, so daß diese mit dem optoelektronischen Element (12) elektrisch verbunden werden können, wobei diese Teile sich über eine leitende Lasche (9, 9') fortsetzen, wobei das an ihrem Platz Befestigen der Zwischeneinrichtung (12) folglich durch Verlötung des leitenden Bodens (10) und der leitenden Lasche (9, 9') mit einer ersten (24) und einer zweiten (25) leitenden Abschlußstelle der Basis (2) erfolgt.

4. Verfahren nach Anspruch 3 zum Schaffen einer Abschlußeinrichtung mit einer optischen Faser (F), dadurch gekennzeichnet, daß das Verfahren einen Verfahrensschritt aufweist zum Einführen der Faser (F) in die zentrale Öffnung (19) bis an den Anschlag gegen den Steg (17), wobei dieser Verfahrensschritt mit Hilfe eines Einführungsteils (42, 45) durchgeführt wird, das zum Führen der Faser (F) ein kegelstumpfförmiges Profil (37, 48) aufweist, und im wesentlichen koaxial zu der zentralen Öffnung (19) der Blende (18) angeordnet ist und daß das Verfahren ebenfalls einen Verfahrensschritt zum Verriegeln der Faser (F) in der Anschlaglage aufweist.

5. Verfahren nach Anspruch 4, dadurch gekennzeichnet, daß das Einführungsteil eine Zentrierbuchse (45) ist, deren vorderer Teil das kegelstumpfförmige Profil (48) aufweist und daß während eines Verfahrensschrittes zum Einführen der Zentrierbuchse (45), diese durch Zusammenarbeit zwischen der Bezugswand (56) der Basis und einem ersten Zentrierrand (49) der Zentrierbuchse (45) koaxial zu dem kegelstumpfförmigen Profil (48) derart zentriert wird, daß letzteres im wesentliche koaxial zu der zentralen Öffnung (19) der Blende (18) zugeführt wird und daß das Verfahren einen Verfahrensschritt aufweist zum an ihrem Platz Verriegeln der Faser (F) in der Zentrierbuchse (45) sowie einen Verfahrensschritt zum Verriegeln der Zentrierbuchse (45) auf der Basis (3), wobei diese Verfahrensschritte den genannten Verfahrensschritt zum Verriegeln der Faser in der Anschlagposition.

6. Verfahren nach Anspruch 4, dadurch gekennzeichnet, daß das Einführungsteil ein Zentrierelement (31) ist, daß das Verfahren einen Verfahrensschritt aufweist zum Einführen einer Haltebuchse (60) mit einer optischen Faser (F), die derart an ihrem Platz (63, 72) auf derselben verriegelt ist, daß sie über eine bestimmte Länge (1) auf der Vorderseite (65) herausragt, wobei die Haltebuchse durch Zusammenarbeit zwischen einem zweiten Zentrierrand (64') der Haltebuchse (60), der koaxial zu der darin befindlichen optischen Faser (F) ist, und der Bezugsfläche (88) der Basis (3) zentriert wird und daß das Verfahren einen Verfahrensschritt aufweist zum an ihrem Platz auf einem Anschlag (87') Verriegeln der Haltebuchse (60), wobei diese Verfahrensschritte den Verfahrensschritt zum an dem Anschlag anliegend Festhalten der Faser bilden.

7. Abschlußeinrichtung für eine optische Faser mit einem optoelektronischen Halbleiterelement, auf dem eine sphärische Linse derart angeordnet ist, daß ein afokales System gebildet wird, wobei das aus dem optoelektronischen Element und der sphärischen Linse bestehende Gebilde in einer Basis an seinem Platz gehalten wird, dadurch gekennzeichnet, daß die Einrichtung eine Zwischeneinrichtung (1) aufweist, die aus einem Gehäuse (40) besteht, auf dessen Boden (10) das aus dem optoelektronischen Element (12) und der sphärischen Linse (15) bestehende Gebilde befestigt ist, sowie mit einer auf einem lateralen Teil (11) des Mikrogehäuses (40) derart an ihrem Platz angeordneten Blende (18), daß diese eine zu der sphärischen Linse (15) koaxiale zentrale Öffnung (19) bildet und einen Durchmesser aufweist, der großer ist als der der Linse und daß die Zwischeneinrichtung (1) an sich derart in der Basis (2, 3, 80) angeordnet ist, daß die zentrale Öffnung (19) der Blende (18) gegenüber einer Bezugsfläche der Basis (2, 3, 80) ausgerichtet ist, daß der Boden (10) des Gehäuses (40) mit dem optoelektronischen Element (12) in elektrischem Kontakt ist, daß die Blende (18) oder ein Steg (17) derart elektrisch leitend sind, daß sie mit dem optoelektronischen Element (12) elektrisch verbunden werden können und daß die Blende oder der Steg (17, 18) sich mittels einer leitenden Lasche (9, 9') fortsetzen, wobei der leitende Boden (10) und die leitende Lasche (9, 9') die leitenden Verbindungen mit der Zwischeneinrichtung (1) bilden.

8. Abschlußeinrichtung nach Anspruch 7, dadurch gekennzeichnet, daß der wenigstens in dem zentralen Teil transparente Steg (17) zwischen der Blende (18) und dem lateralen Teil (11) des Mikrogehäuses (40) derart vorgesehen ist, daß er im Betrieb der Abschlußeinrichtung als Anschlag für eine in die zentrale Öffnung (19) der Blende (18) eingeführte optische Faser (F) wirksam ist. ·

9. Abschlußeinrichtung nach Anspruch 8, dadurch gekennzeichnet, daß die leitenden Verbindungen mit einer ersten (24) und einer zweiten (25) leitenden Anschlußstelle der Basis (2) derart elektrisch verbunden sind, daß ebenfalls gewährleistet wird, daß das Gehäuse (40) auf der Basis (2) an seinem Platz gehalten wird.

10. Abschlußeinrichtung nach einem der Ansprüche 8 oder 9 mit einer optischen Faser, dadurch gekennzeichnet, daß die Einrichtung ein Einführungsteil für die optische Faser aufweist, wobei dieses Teil durch eine Zentrierbuchse (45) gebildet wird, deren vorderes Ende (48') ein kegelstumpfförmiges Profil (48) aufweist, deren Zentralteil (49) einen Zentrierrand (49') hat, der sich koaxial zu dem kegelstumpfförmigen Profil (48) erstreckt und und mit der Bezugsoberfläche (56) der Basis zusammenarbeitet, und zwar zum mit geringem Spielraum den kegelstumpfförmigen Teil (48) der koaxialen Zentrierbuchse (45) an die zentrale Öffnung (19) der Blende (18) heranzuführen, sowie ein Mittel (57) zur Gewährleistung der Verriegelung der Faser. ·

11. Abschlußeinrichtung nach einem der Ansprüche 8 oder 9, mit einer optischen Faser, dadurch gekennzeichnet, daß die Einrichtung eine Zentriervorrichtung (31) aufweist, die ein kegelstumpfförmiges im wesentlichen zu der Öffnung der Blende (18) koaxiales Profil (32) aufweist, eine Haltebuchse (60) mit einer optischen Faser (F), die derart auf dieser Buchse an ihrem Platz (63, 72) verriegelt ist, daß die Faser über eine Länge (1) aus dem vorderen Teil (65) der Haltebuchse herausragt, wobei die Haltebuchse (60) durch Zusammenarbeit zwischen einem zweiten gegenüber der optischen Faser (F) zentrierten Zentrierrand (64') der Haltebuchse (60) und der Bezugsfläche (88) der Basis zentriert wird und daß die Einrichtung ein Mittel (90) zum Verriegeln der Haltebuchse (60) gegen einen Anschlag (87) der Basis (80).

**Claims**

1. A method of manufacturing a terminal device for an optical fibre, including the positioning of an opto-electronic semiconductor element in a base, a ball lens being secured on said element in order to form an afocal system, as well as the making of electric connections, characterized in that it includes the following steps:

a) securing the assembly formed by the ball lens (15) and the opto-electronic element (12) in position on the bottom (10) of a housing (40) having smaller dimensions than the base and comprising a lateral portion (11).

b) centring the central aperture (19) of a diaphragm (18), with respect to the ball lens (15), supported by a lateral portion (11) of the housing (40) said central aperture having a diameter which is substantially equal to the outer diameter of an optical fibre (F) and larger than that of the ball lens (15);

c) securing said diaphragm (18) thus centred in position, thus forming an intermediate component (1);

d) arranging the intermediate component in said base (2, 3, 80) and positioning it with respect to a reference surface (21, 56, 88) thereof by introducing a pin (43) into said central aperture (19) of the diaphragm (18), said pin (43) itself being positioned with respect to a reference contour (41) which cooperates with the reference surface (21, 56, 88);

e) securing the intermediate component (1) thus centred in position in the base (2).

2. A method as claimed in Claim 1, characterized in that it comprises a step for interposing, between the diaphragm and the lateral portion (11) of the housing (40), a spacer (17) whose central portion (17) at least is transparent and which serves as an abutment for an optical fibre (F) introduced into the central aperture (19) of the diaphragm (18) when the terminal device is used.

3. A method as claimed in any one of the Claims 1 or 2, characterized in that the bottom (10) of the housing (40) is electrically conductive, the step involving the securing in position of the opto-electric element (12) being such that the latter is in electric contact with said conductive bottom, (10), the diaphragm (11) or a spacer (17) also being electrically conductive so that it can be electrically connected to the opto-electronic element (12) and being extended by a conductive pad (9, 9'), the securing in position of the intermediate component (12) then being achieved by soldering the conductive bottom (10) and the conductive pad (9, 9') to a first (24) and a second (25) conductive terminal of the base (2).

4. A method as claimed in Claim 3, for providing a terminal device including, an optical fibre (F), characterized in that it includes a step for introducing the fibre (F) into the central aperture (19) until it abuts against the spacer (17), said step being preformed by means of an introductory tool (82, 45) which has been a truncated conical profile (37, 48) for guiding the fibre (F) and which is arranged so as to be substantially coaxial with the central aperture (19) of the diaphragm (18), and in that it also includes a step for locking the fibre (F) in the abutting position.

5. A method as claimed in Claim 4, characterized in that said introductory tool is formed by a centring ferrule (45) whose front portion is provided with said truncated conical profile (48), and in that during a step for introducing the centring ferrule (45) the ferrule is centred by cooperation between the reference surface (56) of the base and a first centring contour (49) of the centring ferrule (45) which is coaxial with said truncated conical profile (48) so that the latter is guided substantially coaxially with respect to the central aperture (19) of the diaphragm (18), said method also comprising a step for locking the fibre (F) in position in the centring ferrule (45) and a step for locking the centring ferrule (45) on the base (3), these steps represent the said step for locking the fibre in the abutting position.

6. A method as claimed in Claim 4, characterized in that said introductory tool is formed by a centring member (31), the method including a step for introducing a holding ferrule (60) provided with an optical fibre (F) which is locked in position (63, 72) thereon so that it projects from the front portion (65) thereof over a given length (1), the holding ferrule being centred by cooperation between a second centring contour (64') of the holding ferrule (60), being coaxial with said optical fibre (F) contained therein, and the reference surface (88) of the base (3), the method also including a step for locking the holding ferrule (60) in position against an abutment (87') this step representing said step for holding the fibre in an abutting position.

7. A terminal device for an optical fibre, comprising an opto-electronic semiconductor element on which there is secured a ball lens so as to form an afocal system, the assembly formed by the opto-electronic element and the ball lens being positioned in a base, characterized in that it comprises an intermediate component (1) which includes a housing (40) on the bottom (10) of which there is secured the assembly formed by the opto-electronic element (12) and the ball lens (15), and a diaphragm (18) which is secured in position on a lateral portion (11) of the housing (40) so that it presents a central aperture (19) which is coaxial with the ball lens (15) and which has a diameter which is larger than the diameter thereof, in that the intermediate component (1) itself is secured in said base (2, 3, 80) so that the central aperture (19) of the diaphragm (18) is positioned with respect to a reference surface of the base (2, 3, 80), in that the bottom (10) of the housing (40) is in electric contact with the opto-electronic element (12), in that the diaphragm (18) or a spacer (17) is electrically conductive so that it is electrically connected to the opto-electronic element (12) and in that the diaphragm or the spacer (17, 18) is extended by way of a conductive pad (9, 9'), the conductive bottom (10) and the conductive pad (9, 9') constituting the electric connections of the intermediate component (1).

8. A terminal device as claimed in Claim 7, characterized in that at least the central portion of the spacer (17) is transparent and the spacer is arranged between the diaphragm (18) and the lateral portion (11) of the housing (40) so that it serves as an abutment for an optical fibre (F) introduced into the central aperture (19) of the diaphragm (18) when the terminal device is used.

9. A terminal device as claimed in Claim 8, characterized in that said conductive connections are electrically connected to a first (24) and a second (25) conductive terminal of the base (2) so that they at the same time ensure that the housing (40) is maintained in position on the base (2).

10. A terminal device as claimed in Claim 8 or 9 and provided with an optical fibre, characterized in that it includes an introductory tool for the optical fibre which is formed by a centring ferrule (45) whose front portion (48') has a truncated conical profile (48), its central portion (49) having a centring contour (49') which is coaxial with the truncated conical profile (48) and which is cooperative with the reference surface (56) of the base in order to guide the truncated conical portion (48) of the centring ferrule (45) so as to be substantially coaxial with the central aperture (19) of the diaphragm (18) and also includes means (57) for locking the fibre.

11. A terminal device as claimed in Claim 8 or 9 and provided with an optical fibre, characterized in that it includes a centring member (31) having a truncated conical profile (32) which is substantially coaxial with the aperture of the diaphragm (18), a holding ferrule (60) provided with an optical fibre (F) which is locked in position (63, 72) thereon so that it projects from the front portion (65) thereof over a given length (1), the holding ferrule (61) being centred by cooperation between a second centring contour (64') of the holding ferrule (60), centred with respect to said optical fibre (F) contained therein, and the reference surface (88) of the base, and in that it includes means (90) for locking the holding ferrule (60) against an abutment (87) of the base (80).

FIG.1a

FIG.1b

FIG.3a

FIG.3b

FIG.3c

FIG.2a

FIG.3d

FIG.2b

FIG.4a

FIG.4b

FIG.9a

FIG.5a

FIG.9b

FIG.5b

FIG.6

5

FIG.7a

FIG.7b

FIG.8a

FIG.8b